# EUROPEAN PATENT SPECIFICATION

(11) **EP 3 646 465 B1**
(45) Date of publication and mention of the grant of the patent: **19.05.2021**
(21) Application number: 18729956.5
(22) Date of filing: 07.06.2018
(51) Int. Cl.: H03K 17/687, H03K 19/003, H03K 17/0812

(54) **PRE-DRIVER**
VORTREIBER
PRÉ-PILOTE

(30) Priority: 28.06.2017 CN 201720767943 U
(43) Date of publication of application: 06.05.2020
(73) Proprietor: Robert Bosch GmbH, 70442 Stuttgart (DE)
(72) Inventor: DING, Qibing, Shanghai 200335 (CN); JIANG, Ming, Shanghai 200335 (CN)
(86) International application number: PCT/EP2018/065068
(87) International publication number: WO 2019/001926

(56) References cited:
- US-A- 5 414 314
- US-A- 5 757 213
- US-A1- 2001 047 220
- US-B2- 7 724 046

## Description

### Technical field

The present invention relates to the field of integrated circuits, in particular to a pre-driver.

### Background art

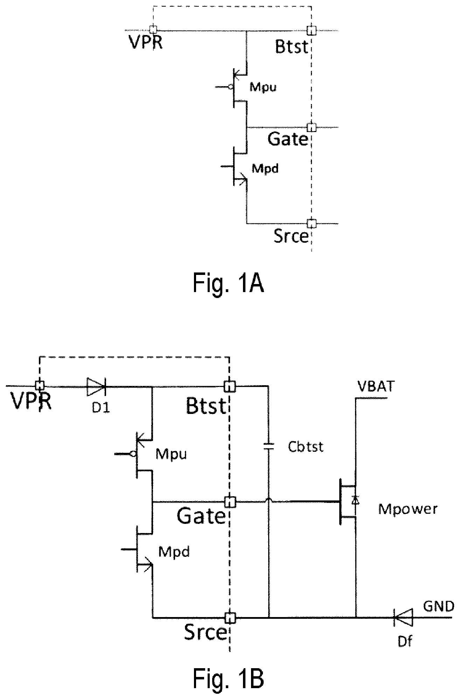

A pre-driver is a basic circuit, used widely in many fields. As shown in fig. 1A, a pre-driver comprises two field effect transistors Mpu and Mpd which have drains connected together and switch on alternately, and the pre-driver has a power supply input pin VPR and three output pins Btst, Gate and Srce. The pre-driver generally may be configured for use as a low-side driver or a high-side driver.

A pre-driver may be used in a vehicle to control the driving of a load by a battery. The scenario shown in fig. 1B is a pre-driver being used as a high-side driver; the driving of a load Lload by a battery VBAT in a vehicle is controlled by controlling a field effect transistor Mpower. In the scenario of fig. 1B, a situation whereby the output pins Gate and Srce are at a negative voltage (-7 V) will occur during operation of the pre-driver. Only a field effect transistor having an isolated N-type ring can bear a negative voltage, therefore the field effect transistor Mpd in an existing pre-driver is generally a field effect transistor having an isolated N-type ring.

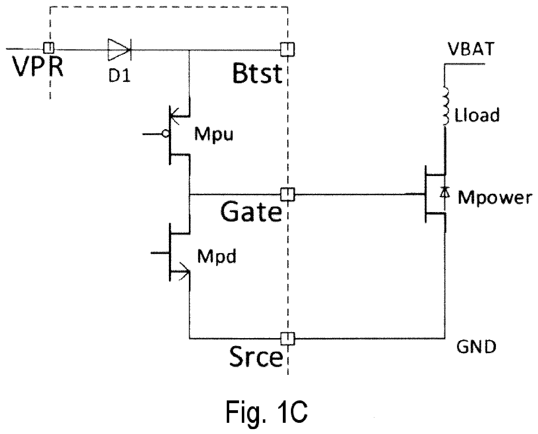

The scenario shown in fig. 1C is a pre-driver being used as a low-side driver; the driving of a load Lload by a battery VBAT in a vehicle is controlled by controlling a field effect transistor Mpower. In the scenario of fig. 1C, if a fault occurs causing the output pin Gate of the pre-driver to be short-circuited to the battery VBAT, the voltage between the output pins Gate and Srce of the pre-driver is 36 V; this requires the field effect transistor Mpd in the pre-driver to be able to bear a maximum voltage of 36 V. However, field effect transistors having an isolated N-type ring can generally only bear a maximum voltage of 20 V, and field effect transistors Mpd in existing pre-drivers are field effect transistors having isolated N-type rings, therefore existing pre-drivers cannot meet the requirement to bear a greater voltage
The document US 7,724,046 B2 discloses an integrated circuit device for switching electrical loads that have an inductive component, the device comprising a power MOS transistor and a driver circuit for driving the gate of the power MOS transistor, the device being configurable for use in either of a high side configuration and a low side configuration.

### Summary

In view of the abovementioned shortcoming in the prior art, the present invention provides a pre-driver capable of bearing a greater voltage according to independent claim 1. Embodiments of the invention are defined as set out in the dependent claims.

A pre-driver according to the invention comprises: a first field effect transistor, with a source thereof being connected to a power supply input pin of the pre-driver, the power supply input pin being connectable to an external power supply; a second field effect transistor, with a drain thereof being connected to a drain of the first field effect transistor and being connected therewith to a first output pin of the pre-driver, and a source of the second field effect transistor being connected to a second output pin of the pre-driver, wherein the first field effect transistor and the second field effect transistor are controlled to switch on alternately; a third field effect transistor, with a source thereof being connected to ground; a reverse protection circuit, located between the second output pin and a drain of the third field effect transistor, and used for preventing current flow from the ground to the second output pin; and a first control circuit, connected to a gate of the third field effect transistor and to the first output pin, and used for causing the third field effect transistor to be in an OFF state when a control signal from the outside indicates that the pre-driver is used as a high-side driver or when the control signal indicates that the pre-driver is used as a low-side driver and a voltage of the first output pin is greater than a voltage threshold, and for causing the third field effect transistor to be in an ON state when the control signal indicates that the pre-driver is used as a low-side driver and a voltage of the first output pin is not greater than the voltage threshold.

It can be seen from the description above that in the case where the pre-driver is configured as a low-side driver and the voltage of the first output pin is greater than the voltage threshold, the voltage of the first output pin will be borne by the second and third field effect transistors jointly, not just borne by the second field effect transistor alone, so that the pre-driver is able to bear a greater voltage on account of comprising the third field effect transistor.

### Description of the accompanying drawings

Features, characteristics, advantages and benefits of the present invention will become obvious through the following detailed description, which makes reference to the accompanying drawings.
Fig. 1A shows a schematic diagram of an existing pre-driver.
Fig. 1B shows a schematic diagram of an existing pre-driver being used as a high-side driver.
Fig. 1C shows a schematic diagram of an existing pre-driver being used as a low-side driver.
Fig. 2 shows a schematic diagram of a pre-driver according to an embodiment of the present invention.

### Particular embodiments

Various embodiments of the present invention are described in detail below with reference to the accompanying drawings.

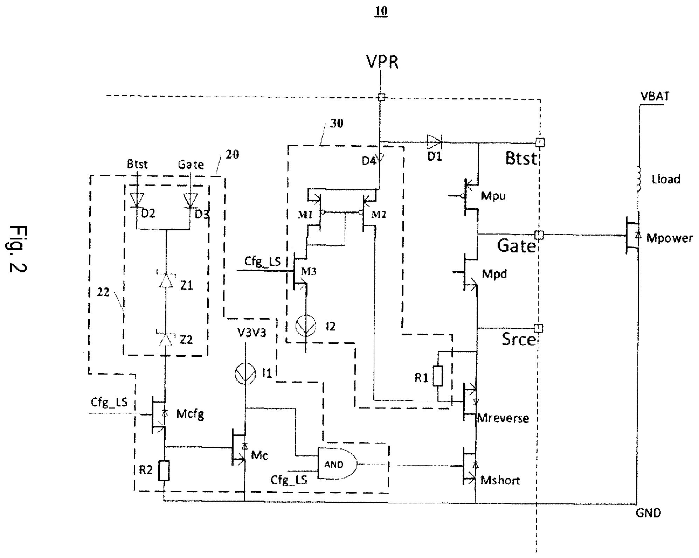

Fig. 2 shows a schematic diagram of a pre-driver according to an embodiment of the present invention. As shown in fig. 2, the pre-driver 10 may comprise field effect transistors Mpu, Mpd, Mreverse and Mshort, and control circuits 20 and 30. The field effect transistor Mpd is a field effect transistor having an isolated N-type ring.

A source S of the field effect transistor Mpu is connected to a power supply input pin VPR and an output pin Btst of the pre-driver 10, and a drain D of the field effect transistor Mpu is connected to a drain D of the field effect transistor Mpd and connected therewith to an output pin Gate of the pre-driver 10. A source S of the field effect transistor Mpd is connected to a source S of the field effect transistor Mreverse and connected therewith to an output pin Srce of the pre-driver 10. A drain D of the field effect transistor Mreverse is connected to a drain D of the field effect transistor Mshort, and a source S of the field effect transistor Mshort is connected to ground GND. Gates G of the field effect transistors Mpu and Mpd are supplied with control signals, such that the field effect transistors Mpu and Mpd are controlled to switch on alternately.

The control circuit 20 is connected to a gate G of the field effect transistor Mshort and to the output pins Btst and Gate, and used for causing the field effect transistor Mshort to be in an OFF state when a control signal Cfg_LS from the outside indicates that the pre-driver 10 is used as a high-side driver or when the control signal Cfg_LS indicates that the pre-driver 10 is used as a low-side driver and a voltage of the output pin Gate or Btst is greater than a voltage threshold TH, and for causing the field effect transistor Mshort to be in an ON state when the control signal Cfg_LS indicates that the pre-driver 10 is used as a low-side driver and voltages of the output pins Gate and Btst are both not greater than the voltage threshold TH. In one aspect, a HIGH control signal Cfg_LS is used to indicate that the pre-driver 10 is used as a low-side driver; a LOW control signal Cfg_LS is used to indicate that the pre-driver 10 is used as a high-side driver. Here, the voltage threshold TH is chosen to have a suitable value such that if the voltage of the output pin Gate or Btst is greater than the voltage threshold TH, this means that a voltage which the field effect transistor Mpd is about to bear might reach the maximum voltage which the field effect transistor Mpd is capable of bearing.

The control circuit 30 is connected to a gate G of the field effect transistor Mreverse, and used for causing the field effect transistor Mreverse to be in an ON state when the control signal Cfg_LS indicates that the pre-driver 10 is used as a low-side driver, and for causing the field effect transistor Mreverse to be in an OFF state when the control signal Cfg_LS indicates that the pre-driver 10 is used as a high-side driver.

In one aspect, the control circuit 20 may comprise a voltage drop circuit 22, field effect transistors Mcfg and Mc, a resistance R2, a current source I1 and an AND gate.

One end of the voltage drop circuit 22 is connected to the output pins Gate and Btst; another end of the voltage drop circuit 22 is connected to a drain D of the field effect transistor Mcfg.

A source S of the field effect transistor Mcfg is connected to a gate G of the field effect transistor Mc, and a gate G of the field effect transistor Mcfg is supplied with the control signal Cfg_LS.

A source S of the field effect transistor Mc is connected to ground GND, and a drain D of the field effect transistor Mc is connected to the current source I1 and to an input end of the AND gate. The resistance R2 is connected between the gate G and the source S of the field effect transistor Mc.

Another input end of the AND gate is supplied with the control signal Cfg_LS, and an output end of the AND gate is connected to the gate G of the field effect transistor Mshort.

In one aspect, the voltage drop circuit 22 may comprise diodes D2 and D3, and Zener diodes Z1 and Z2. Anodes of the diodes D2 and D3 are connected to the output pins Btst and Gate respectively, and cathodes of the diodes D2 and D3 are connected together, and together connected to a cathode of the Zener diode Z1. An anode of the Zener diode Z1 is connected to a cathode of the Zener diode Z2, and an anode of the Zener diode Z2 is connected to the drain D of the field effect transistor Mcfg. Here, the Zener diodes Z1 and Z2 may each stabilize voltage at about 5 V for example.

In one aspect, the control circuit 30 may comprise field effect transistors M1, M2 and M3, a current source I2 and a resistance R1.

Sources S of the field effect transistors M1 and M2 are connected to the power supply input pin VPR; gates G of the field effect transistors M1 and M2 are connected together, and connected to a drain D of the field effect transistor M1. A drain D of the field effect transistor M2 is connected to the gate G of the field effect transistor Mreverse.

A drain D of the field effect transistor M3 is connected to the drain D of the field effect transistor M1, a source S of the field effect transistor M3 is connected to the current source I2, and a gate G of the field effect transistor M3 is supplied with the control signal Cfg_LS.

The resistance R1 is connected between the gate G and the source S of the field effect transistor Mreverse.

The field effect transistor Mreverse and the control circuit 30 form a reverse protection circuit of the pre-driver 10, preventing current flow from ground GND to the output pin Srce.

The operating principles of the pre-driver 10 are described below.

When the pre-driver 10 is to be configured as a high-side driver, the control signal Cfg_LS is set to LOW. In this case, the gates G of the field effect transistors M3 and Mcfg and one of the input ends of the AND gate are supplied with the LOW control signal Cfg_LS.

In the control circuit 20, when one of the input ends of the AND gate is supplied with the LOW control signal Cfg_LS, the output end of the AND gate will output a LOW level to the gate G of the field effect transistor Mshort, regardless of whether the other input end of the AND gate receives a HIGH level or a LOW level, so that the field effect transistor Mshort is in an OFF state.

In the control circuit 30, the field effect transistor M3 is in an OFF state when the gate G thereof is supplied with the LOW control signal Cfg_LS, so that the current flowing through the field effect transistor M1 is zero. In this case, due to a current mirror action of the field effect transistors M1 and M2, the current flowing through the field effect transistor M2 is zero, hence the current flowing through the resistance R1 is also zero, so that the voltage between the gate G and the source S of the field effect transistor Mreverse is zero; this is equivalent to the gate G of the field effect transistor Mreverse being supplied with a LOW level, so that the field effect transistor Mreverse is in an OFF state.

Clearly, when the pre-driver 10 is configured as a high-side driver, the field effect transistors Mshort and Mreverse are both in an OFF state. When the output pins Gate and Srce of the pre-driver 10 are at a negative voltage (e.g. -7 V), there is a voltage drop from ground GND to the output pin Srce. However, since the field effect transistor Mreverse, when in an OFF state, is equivalent to a diode having an anode and a cathode pointing to the output pin Srce and ground GND respectively, the voltage drop from ground GND to the output pin Srce cannot cause current flow from ground GND to the output pin Srce, i.e. the field effect transistor Mreverse in an OFF state prevents the flow of current from ground GND to the output pin Srce, so that the field effect transistor Mreverse and the control circuit 30 thereof have a reverse protection action on the pre-driver 10 when the pre-driver 10 is configured as a high-side driver.

When the pre-driver 10 is to be configured as a low-side driver, the control signal Cfg_LS is set to HIGH. In this case, the gates G of the field effect transistors M3 and Mcfg and one of the input ends of the AND gate are supplied with the HIGH control signal Cfg_LS.

In the control circuit 20, the field effect transistor Mcfg is in an ON state when the gate G thereof is supplied with the HIGH control signal Cfg_LS, so a current flows through a circuit formed by the diodes D2 and D3, the Zener diodes Z1 and Z2, the field effect transistor Mcfg and R2, and a voltage drop correspondingly occurs across R2; this voltage drop is a VGS actual voltage between the gate G and the source S of the field effect transistor Mc. When the voltages of the output pins Gate and Btst have both not reached the voltage threshold TH, the VGS actual voltage of the field effect transistor Mc (i.e. the voltage drop across R2) is less than a VGS switch-on voltage of the field effect transistor Mc; this is equivalent to the gate G of the field effect transistor Mc being supplied with a LOW level, so the field effect transistor Mc is in an OFF state. With the field effect transistor Mc in an OFF state, the drain D of the field effect transistor Mc is at a HIGH level, so the drain D of the field effect transistor Mc supplies a HIGH level to the other input end of the AND gate. In this case, the two input ends of the AND gate are both supplied with a HIGH level, so the AND gate supplies a HIGH level via the output end thereof to the gate G of the field effect transistor Mshort, hence the field effect transistor Mshort is in an ON state.

In the control circuit 20, the field effect transistor M3 is in an ON state when the gate G thereof is supplied with the HIGH control signal Cfg_LS, so that a current DL flows through the field effect transistor M1. In this case, due to the current mirror action of the field effect transistors M1 and M2, there is also a current DL flowing through the field effect transistor M2, and the current DL also flows through the resistance R1. Thus, a voltage drop occurs across the resistance R1; the voltage drop is a VGS actual voltage between the gate G and the source S of the field effect transistor Mreverse and is greater than a VGS switch-on voltage between the gate G and the source S of the field effect transistor Mreverse. This is equivalent to the gate G of the field effect transistor Mreverse being supplied with a HIGH level, so the field effect transistor Mreverse is in an ON state.

Clearly, when the pre-driver 10 is configured as a low-side driver and the voltages of the output pins Gate and Btst have both not reached the voltage threshold TH, the field effect transistors Mshort and Mreverse are both in an ON state.

When, for example due to a fault etc., the voltage(s) of the output pin(s) Gate and/or Btst is/are greater than the voltage threshold TH, the current flowing through the circuit formed by the diodes D2 and D3, the Zener diodes Z1 and Z2, the field effect transistor Mcfg and R2 increases, so that the voltage drop across R2 (i.e. the VGS actual voltage between the gate G and the source S of the field effect transistor Mc) increases and is greater than the VGS switch-on voltage of the field effect transistor Mc; this is equivalent to the gate G of the field effect transistor Mc being supplied with a HIGH level, so the field effect transistor Mc is in an ON state. With the field effect transistor Mc in an ON state, the drain D of the field effect transistor Mc is at a LOW level, so the drain D of the field effect transistor Mc supplies a LOW level to the other input end of the AND gate. In this case, even if one of the input ends of the AND gate is supplied with a HIGH control signal Cfg_LS, the AND gate outputs a LOW level and supplies this to the gate G of the field effect transistor Mshort, so that the field effect transistor Mshort is in an OFF state.

Therefore, in the case where the pre-driver 10 is configured as a low-side driver and the voltage(s) of the output pin(s) Gate and/or Btst is/are greater than the voltage threshold TH, the voltages of the output pins Gate and Btst will be borne by the field effect transistors Mpd and Mshort jointly, not just borne by the field effect transistor Mpd alone, so that the pre-driver 10 is able to bear a greater voltage.

It can be seen from the description above that the pre-driver 10 in this embodiment is able to bear a greater voltage on account of comprising the field effect transistor Mshort, and at the same time has reverse protection capability on account of comprising the field effect transistor Mreverse.

### Other variants

Those skilled in the art should understand that in other embodiments, the pre-driver 10 may also comprise a diode D1 connected between the power supply input pin VPR and the field effect transistor Mpu and/or a diode D4 connected between the power supply input pin VPR and the control circuit 30, to prevent a current of the pre-driver 10 from flowing in reverse to an external power supply connected to the power supply input pin VPR and thereby damaging the external power supply.

Those skilled in the art should understand that although the control circuit 30 is formed by the field effect transistors M1, M2 and M3, the current source I2 and the resistance R1 in the embodiment above, the present invention is not limited to this. In other embodiments, the control circuit 30 may also be realized in other suitable ways.

Those skilled in the art should understand that although the field effect transistor Mreverse and the control circuit 30 form a reverse protection circuit of the pre-driver 10 for preventing current flow from ground GND to the output pin Srce in the embodiment above, the present invention is not limited to this. In other embodiments, it would for example also be possible to use a diode to replace the field effect transistor Mreverse and the control circuit 30 to serve as a reverse protection circuit of the pre-driver 10 for preventing current flow from ground GND to the output pin Srce. In this case, the output pin Srce and the drain of the field effect transistor Mshort are connected to an anode and a cathode respectively of the diode serving as the reverse protection circuit of the pre-driver 10 for preventing current flow from ground GND to the output pin Srce.

Those skilled in the art should understand that although the voltage drop circuit 22 is formed of the two diodes D2 and D3 and the two Zener diodes Z1 and Z2 in the embodiment above, the present invention is not limited to this. In other embodiments of the present utility model, the voltage drop circuit 22 may comprise one or more than two Zener diodes, or the voltage drop circuit 22 may not comprise the diodes D2 and D3.

Those skilled in the art should understand that although the control circuit 20 comprises the field effect transistor Mcfg in the embodiment above, the present invention is not limited to this. In other embodiments, the control circuit 20 may also not comprise the field effect transistor Mcfg.

Those skilled in the art should understand that although the pre-driver 10 comprises the output pin Btst in the embodiment above, the present invention is not limited to this. In other embodiments of the present invention, the pre-driver 10 may also not comprise the output pin Btst.

Those skilled in the art should understand that although the field effect transistor Mpd is a field effect transistor having an isolated N-type ring in the embodiment above, the present invention is not limited to this. In other embodiments, the field effect transistor Mpd may be another suitable type of field effect transistor.

Those skilled in the art will understand that various alterations, amendments and/or adjustments could be made to all embodiments disclosed in the present disclosure without deviating from the substance of the invention. Thus, the scope of protection of the present invention is defined by the attached claims.

## Claims

1. Pre-driver comprising:
a first field effect transistor (Mpu), with a source thereof being connected to a power supply input pin (VPR) of the pre-driver, the power supply input pin being connectable to an external power supply (VPR);
a second field effect transistor (Mpd), with a drain thereof being connected to a drain of the first field effect transistor (Mpu) and being connected therewith to a first output pin (Gate) of the pre-driver, and a source of the second field effect transistor being connected to a second output pin (Srce) of the pre-driver, wherein the first field effect transistor (Mpu) and the second field effect transistor (Mpd) are controlled to switch on alternately;
a third field effect transistor (Mshort), with a source thereof being connected to ground;
a reverse protection circuit (Mreverse, 30), located between the second output pin (Srce) and a drain of the third field effect transistor (Mshort), and used for preventing current flow from the ground to the second output pin (Srce); and
a first control circuit (20), connected to a gate of the third field effect transistor (Mshort) and to the first output pin (Gate), and used for causing the third field effect transistor (Mshort) to be in an OFF state when a control signal from the outside (Cfg_LS) indicates that the pre-driver is used as a high-side driver or when the control signal (Cfg_LS) indicates that the pre-driver is used as a low-side driver and a voltage of the first output pin (Gate) is greater than a voltage threshold, and for causing the third field effect transistor (Mshort) to be in an ON state when the control signal (Cfg_LS) indicates that the pre-driver is used as a low-side driver and a voltage of the first output pin is not greater than the voltage threshold.

2. Pre-driver according to Claim 1, **characterized in that**
the source of the first field effect transistor (Mpu) is also connected to a third output pin (Btst) of the pre-driver, and
the first control circuit (20) is also used for causing the third field effect transistor (Mshort) to be in an OFF state when the control signal (Cfg_LS) indicates that the pre-driver is used as a low-side driver and a voltage of the first output pin (Gate) or a voltage of the third output pin (Btst) is greater than the voltage threshold.

3. Pre-driver according to Claim 2, **characterized in that** the first control circuit (20) comprises:
a voltage drop circuit (22), with one end thereof being connected to the first output pin (Gate) and the third output pin (Btst);
a fourth field effect transistor (Mcfg), with a drain thereof being connected to another end of the voltage drop circuit (22), and a gate of the fourth field effect transistor being supplied with the control signal (Cfg_LS), wherein the control signal (Cfg_LS) is HIGH when the control signal (Cfg_LS) indicates that the pre-driver is used as a low-side driver, and the control signal (Cfg_LS) is LOW when the control signal (Cfg_LS) indicates that the pre-driver is used as a high-side driver;
a fifth field effect transistor (Mc), with a gate, a drain and a source thereof being connected to a source of the fourth field effect transistor (Mcfg), a first current source (11) and ground (GND) respectively, and a first resistance (R2) being connected between the gate and the source of the fifth field effect transistor (Mc); and
an AND gate (AND), with one input end thereof being connected to the drain of the fifth field effect transistor (Mc), another input end of the AND gate being supplied with the control signal (Cfg_LS), and an output end of the AND gate being connected to the gate of the third field effect transistor (Mshort).

4. Pre-driver according to Claim 3, **characterized in that** the voltage drop circuit (22) comprises:
a first diode (D3), with an anode thereof being connected to the first output pin (Gate);
a second diode (D2), with an anode thereof being connected to the third output pin (Btst); and
at least one series-connected Zener diode (Z1, Z2), connected between respective cathodes of the first diode (D3) and the second diode (D2) and the drain of the fourth field effect transistor (Mcfg).

5. Pre-driver according to any one of Claims 1 - 4, **characterized in that** the reverse protection circuit comprises:
a sixth field effect transistor (Mreverse), with a source and a drain thereof being connected to the second output pin (Srce) and the drain of the third field effect transistor (Mshort) respectively; and
a second control circuit (30), connected to a gate of the sixth field effect transistor (Mreverse), and being used for causing the sixth field effect transistor (Mreverse) to be in an ON state when the control signal (Cfg_LS) indicates that the pre-driver is used as a low-side driver, and for causing the sixth field effect transistor (Mreverse) to be in an OFF state when the control signal (Cfg_LS) indicates that the pre-driver is used as a high-side driver.

6. Pre-driver according to Claim 5, **characterized in that** the second control circuit (30) comprises:
a seventh field effect transistor (M1) and an eighth field effect transistor (M2), wherein respective gates of the seventh field effect transistor (M1) and the eighth field effect transistor (M2) are connected together and connected to a drain of the seventh field effect transistor (M1), respective sources of the seventh field effect transistor (M1) and the eighth field effect transistor (M2) are connected to the power supply input pin (VPR), and a drain of the eighth field effect transistor (M2) is connected to the gate of the sixth field effect transistor (Mreverse);
a ninth field effect transistor (M3), with a drain thereof being connected to the drain of the seventh field effect transistor (M1), a source of the ninth field effect transistor being connected to a second current source (12), and a gate of the ninth field effect transistor being supplied with the control signal (Cfg_LS), wherein the control signal (Cfg_LS) is HIGH when the control signal (Cfg_LS) indicates that the pre-driver is used as a low-side driver, and the control signal (Cfg_LS) is LOW when the control signal (Cfg_LS) indicates that the pre-driver is used as a high-side driver; and
a second resistance (R1), connected between the gate and the source of the sixth field effect transistor (Mreverse).

7. Pre-driver according to Claim 1, **characterized in that** the second field effect transistor (Mpd) is a field effect transistor having an isolated N-type ring.

## Patentansprüche

1. Voransteuereinrichtung, die Folgendes umfasst:
einen ersten Feldeffekttransistor (Mpu), dessen Source mit einem Stromversorgungseingangsanschluss (VPR) der Voransteuereinrichtung verbunden ist, wobei der Stromversorgungseingangsanschluss mit einer externen Stromversorgung (VPR) verbindbar ist;
einen zweiten Feldeffekttransistor (Mpd), dessen Drain mit einem Drain des ersten Feldeffekttransistors (Mpu) verbunden ist und damit mit einem ersten Ausgangsanschluss (Gate) der Voransteuereinrichtung verbunden ist und wobei eine Source des zweiten Feldeffekttransistors mit einem zweiten Ausgangsanschluss (Srce) der Voransteuereinrichtung verbunden ist, wobei der erste Feldeffekttransistor (Mpu) und der zweite Feldeffekttransistor (Mpd) so gesteuert werden, dass sie sich abwechselnd einschalten;
einen dritten Feldeffekttransistor (Mshort), dessen Source mit Masse verbunden ist;
eine Umkehrschutzschaltung (Mreverse, 30) die sich zwischen dem zweiten Ausgangsanschluss (Srce) und einem Drain des dritten Feldeffekttransistors (Mshort) befindet und verwendet wird, um zu verhindern, dass ein Strom von Masse zu dem zweiten Ausgangsanschluss (Srce) fließt; und
eine erste Steuerschaltung (20), die mit einem Gate des dritten Feldeffekttransistors (Mshort) und mit dem ersten Ausgangsanschluss (Gate) verbunden ist und verwendet wird, um zu bewirken, dass der dritte Feldeffekttransistor (Mshort) in einem AUS-Zustand ist, wenn ein Steuersignal von außerhalb (Cfg_LS) angibt, dass die Voransteuereinrichtung als eine hochseitige Ansteuereinrichtung verwendet wird, oder wenn das Steuersignal (Cfg_LS) angibt, dass die Voransteuereinrichtung als eine tiefseitige Ansteuereinrichtung verwendet wird und eine Spannung des ersten Ausgangsanschlusses (Gate) größer als ein Spannungsschwellenwert ist, und um zu bewirken, dass der dritte Feldeffekttransistor (Mshort) in einem EIN-Zustand ist, wenn das Steuersignal (Cfg_LS) angibt, dass die Voransteuereinrichtung als eine tiefseitige Ansteuereinrichtung verwendet wird und eine Spannung des ersten Ausgangsanschluss nicht größer als der Spannungsschwellenwert ist.

2. Voransteuereinrichtung nach Anspruch 1, **dadurch gekennzeichnet, dass**
die Source des ersten Feldeffekttransistors (Mpu) außerdem mit einem dritten Ausgangsanschluss (Btst) der Voransteuereinrichtung verbunden ist und
die erste Steuerschaltung (20) außerdem verwendet wird, um zu bewirken, dass der dritte Feldeffekttransistor (Mshort) in einem AUS-Zustand ist, wenn das Steuersignal (Cfg-LS) angibt, dass die Voransteuereinrichtung als eine tiefseitige Ansteuereinrichtung verwendet wird, und eine Spannung des ersten Ausgangsanschlusses (Gate) oder eine Spannung des dritten Ausgangsanschlusses (Btst) größer als der Spannungsschwellenwert ist.

3. Voransteuereinrichtung nach Anspruch 2, **dadurch gekennzeichnet, dass** die erste Steuerschaltung (20) Folgendes umfasst:
eine Spannungsabfallschaltung (22), wovon ein Ende mit dem ersten Ausgangsanschluss (Gate) und dem dritten Ausgangsanschluss (Btst) verbunden ist;
einen vierten Feldeffekttransistor (Mcfg), dessen Drain mit einem anderen Ende der Spannungsabfallschaltung (22) verbunden ist, wobei ein Gate des vierten Feldeffekttransistors mit dem Steuersignal (Cfg_LS) beliefert wird, wobei das Steuersignal (Cfg_LS) HOCH ist, wenn das Steuersignal (Cfg_LS) angibt, dass die Voransteuereinrichtung als eine tiefseitige Ansteuereinrichtung verwendet wird, und das Steuersignal (Cfg_LS) NIEDRIG ist, wenn das Steuersignal (Cfg_LS) angibt, dass die Voransteuereinrichtung als eine hochseitige Ansteuereinrichtung verwendet wird;
einen fünften Feldeffekttransistor (Mc), dessen Gate, Drain und Source jeweils mit einer Source des vierten Feldeffekttransistors (Mcfg), einer ersten Stromquelle (I1) und Masse (GND) verbunden sind und wobei ein erster Widerstand (R2) zwischen dem Gate und der Source des fünften Feldeffekttransistors (Mc) angeschlossen ist; und
ein UND-Gate (UND), dessen eines Eingangsende mit dem Drain des fünften Feldeffekttransistors (Mc) verbunden ist, wobei ein anderes Eingangsende des UND-Gates mit dem Steuersignal (Cfg_LS) beleifert wird und ein Ausgangsende des UND-Gates mit dem Gate des dritten Feldeffekttransistors (Mshort) verbunden ist.

4. Voransteuereinrichtung nach Anspruch 3, **dadurch gekennzeichnet, dass** die Spannungsabfallschaltung (22) Folgendes umfasst:
eine erste Diode (D3), deren Anode mit dem ersten Ausgangsanschluss (Gate) verbunden ist;
eine zweite Diode (D2), deren Anode mit dem dritten Ausgangsanschluss (Btst) verbunden ist; und
mindestens eine in Reihe geschaltete Zener-Diode (Z1, Z2), die zwischen jeweiligen Kathoden der ersten Diode (D3) und der zweiten Diode (D2) und dem Drain des vierten Feldeffekttransistors (Mcfg) angeschlossen ist.

5. Voransteuereinrichtung nach einem der Ansprüche 1-4, **dadurch gekennzeichnet, dass** die Umkehrschutzschaltung Folgendes umfasst:
einen sechsten Feldeffekttransistor (Mreverse), dessen Source und Drain jeweils mit dem zweiten Ausgangsanschluss (Srce) und dem Drain des dritten Feldeffekttransistors (Mshort) verbunden sind; und
eine zweite Steuerschaltung (30), die mit einem Gate des sechsten Feldeffekttransistors (Mreverse) verbunden ist und verwendet wird, um zu bewirken, dass der sechste Feldeffekttransistor (Mreverse) in einem EIN-Zustand ist, wenn das Steuersignal (Cfg_LS) angibt, dass die Voransteuereinrichtung als eine tiefseitige Ansteuereinrichtung verwendet wird, und um zu bewirken, dass der sechste Feldeffekttransistor (Mreverse) in einem AUS-Zustand ist, wenn das Steuersignal (Cfg_LS) angibt, dass die Voransteuereinrichtung als eine hochseitige Ansteuereinrichtung verwendet wird.

6. Voransteuereinrichtung nach Anspruch 5, **dadurch gekennzeichnet, dass** die zweite Steuerschaltung (30) Folgendes umfasst:
einen siebten Feldeffekttransistor (M1) und einen achten Feldeffekttransistor (M2), wobei jeweilige Gates des siebten Feldeffekttransistors (M1) und des achten Feldeffekttransistors (M2) miteinander verbunden sind und mit einem Drain des siebten Feldeffekttransistors (M1) verbunden sind, wobei jeweilige Sources des siebten Feldeffekttransistors (M1) und des achten Feldeffekttransistors (M2) mit dem Stromversorgungseingangsanschluss (VPR) verbunden sind und ein Drain des achten Feldeffekttransistors (M2) mit dem Gate des sechsten Feldeffekttransistors (Mreverse) verbunden ist;
einen neunten Feldeffekttransistor (M3), dessen Drain mit dem Drain des siebten Feldeffekttransistors (M1) verbunden ist, wobei eine Source des neunten Feldeffekttransistors mit einer zweiten Stromquelle (I2) verbunden ist und ein Gate des neunten Feldeffekttransistors mit dem Steuersignal (Cfg_LS) beliefert wird, wobei das Steuersignal (Cfg_LS) HOCH ist, wenn das Steuersignal (Cfg_LS) angibt, dass die Voransteuereinrichtung als eine tiefseitige Ansteuereinrichtung verwendet wird, und das Steuersignal (Cfg_LS) NIEDRIG ist, wenn das Steuersignal (Cfg_LS) angibt, dass die Voransteuereinrichtung als eine hochseitige Ansteuereinrichtung verwendet wird; und
einen zweiten Widerstand (R1), der zwischen dem Gate und der Source des sechsten Feldeffekttransistors (Mreverse) angeschlossen ist.

7. Voransteuereinrichtung nach Anspruch 1, **dadurch gekennzeichnet, dass** der zweite Feldeffekttransistor (Mpd) ein Feldeffekttransistor mit einem isolierten N-Typ-Ring ist.

## Revendications

1. Pré-excitateur comportant :
un premier transistor à effet de champ (Mpu), dont une source est reliée à une broche d'entrée d'alimentation (VPR) du pré-excitateur, la broche d'entrée d'alimentation pouvant être reliée à une alimentation externe (VPR) ;
un deuxième transistor à effet de champ (Mpd), dont un drain est relié à un drain du premier transistor à effet de champ (Mpu) et qui est relié avec celui-ci à une première broche de sortie (Gate) du pré-excitateur, et une source du deuxième transistor à effet de champ étant reliée à une deuxième broche de sortie (Srce) du pré-excitateur, le premier transistor à effet de champ (Mpu) et le deuxième transistor à effet de champ (Mpd) étant commandés pour devenir passants en alternance ;
un troisième transistor à effet de champ (Mshort), dont une source est reliée à la terre ;
un circuit de protection inverse (Mreverse, 30), situé entre la deuxième broche de sortie (Srce) et un drain du troisième transistor à effet de champ (Mshort), et utilisé pour empêcher une circulation de courant de la terre à la deuxième broche de sortie (Srce) ; et
un premier circuit (20) de commande, relié à une grille du troisième transistor à effet de champ (Mshort) et à la première broche de sortie (Gate), et utilisé pour faire en sorte que le troisième transistor à effet de champ (Mshort) soit dans un état BLOQUE lorsqu'un signal de commande provenant de l'extérieur (Cfg_LS) indique que le pré-excitateur est utilisé comme excitateur côté haut ou lorsque le signal de commande (Cfg_LS) indique que le pré-excitateur est utilisé comme excitateur côté bas et lorsqu'une tension de la première broche de sortie (Gate) est supérieure à un seuil de tension, et pour faire en sorte que le troisième transistor à effet de champ (Mshort) soit dans un état PASSANT lorsque le signal de commande (Cfg_LS) indique que le pré-excitateur est utilisé comme excitateur côté bas et lorsqu'une tension de la première broche de sortie n'est pas supérieure au seuil de tension.

2. Pré-excitateur selon la revendication 1, **caractérisé en ce que**
la source du premier transistor à effet de champ (Mpu) est également reliée à une troisième broche de sortie (Btst) du pré-excitateur, et **en ce que**
le premier circuit (20) de commande est également utilisé pour faire en sorte que le troisième transistor à effet de champ (Mshort) soit dans un état BLOQUE lorsque le signal de commande (Cfg_LS) indique que le pré-excitateur est utilisé comme excitateur côté bas et lorsqu'une tension de la première broche de sortie (Gate) ou une tension de la troisième broche de sortie (Btst) est supérieure au seuil de tension.

3. Pré-excitateur selon la revendication 2, **caractérisé en ce que** le premier circuit (20) de commande comporte :
un circuit (22) de chute de tension, dont une extrémité est reliée à la première broche de sortie (Gate) et à la troisième broche de sortie (Btst) ;
un quatrième transistor à effet de champ (Mcfg), dont un drain est relié à une autre extrémité du circuit (22) de chute de tension, et une grille du quatrième transistor à effet de champ se voyant fournir le signal de commande (Cfg_LS), le signal de commande (Cfg_LS) étant HAUT lorsque le signal de commande (Cfg_LS) indique que le pré-excitateur est utilisé comme excitateur côté bas, et le signal de commande (Cfg_LS) étant BAS lorsque le signal de commande (Cfg_LS) indique que le pré-excitateur est utilisé comme excitateur côté haut ;
un cinquième transistor à effet de champ (Mc), dont une grille, un drain et une source sont respectivement reliés à une source du quatrième transistor à effet de champ (Mcfg), à une première source de courant (I1) et à la terre (GND), et une première résistance (R2) étant branchée entre la grille et la source du cinquième transistor à effet de champ (Mc) ; et
une porte ET (ET), dont une extrémité d'entrée est reliée au drain du cinquième transistor à effet de champ (Mc), une autre extrémité d'entrée de la porte ET se voyant fournir le signal de commande (Cfg_LS), et une extrémité de sortie de la porte ET étant reliée à la grille du troisième transistor à effet de champ (Mshort) .

4. Pré-excitateur selon la revendication 3, **caractérisé en ce que** le circuit (22) de chute de tension comporte :
une première diode (D3), dont une anode est reliée à la première broche de sortie (Gate) ;
une deuxième diode (D2), dont une anode est reliée à la troisième broche de sortie (Btst) ; et
au moins une diode Zener (Z1, Z2) branchée en série, branchée entre des cathodes respectives de la première diode (D3) et de la deuxième diode (D2) et le drain du quatrième transistor à effet de champ (Mcfg).

5. Pré-excitateur selon l'une quelconque des revendications 1 à 4, **caractérisé en ce que** le circuit de protection inverse comporte :
un sixième transistor à effet de champ (Mreverse), dont une source et un drain sont respectivement reliés à la deuxième broche de sortie (Srce) et au drain du troisième transistor à effet de champ (Mshort) ; et
un deuxième circuit (30) de commande, relié à une grille du sixième transistor à effet de champ (Mreverse), et qui est utilisé pour faire en sorte que le sixième transistor à effet de champ (Mreverse) soit dans un état PASSANT lorsque le signal de commande (Cfg_LS) indique que le pré-excitateur est utilisé comme excitateur côté bas, et pour faire en sorte que le sixième transistor à effet de champ (Mreverse) soit dans un état BLOQUE lorsque le signal de commande (Cfg_LS) indique que le pré-excitateur est utilisé comme excitateur côté haut.

6. Pré-excitateur selon la revendication 5, **caractérisé en ce que** le deuxième circuit (30) de commande comporte :
un septième transistor à effet de champ (M1) et un huitième transistor à effet de champ (M2), des grilles respectives du septième transistor à effet de champ (M1) et du huitième transistor à effet de champ (M2) étant reliées entre elles et reliées à un drain du septième transistor à effet de champ (M1), des sources respectives du septième transistor à effet de champ (M1) et du huitième transistor à effet de champ (M2) étant reliées à la broche d'entrée d'alimentation (VPR), et un drain du huitième transistor à effet de champ (M2) étant relié à la grille du sixième transistor à effet de champ (Mreverse) ;
un neuvième transistor à effet de champ (M3), dont un drain est relié au drain du septième transistor à effet de champ (M1), une source du neuvième transistor à effet de champ étant reliée à une deuxième source de courant (I2), et une grille du neuvième transistor à effet de champ se voyant fournir le signal de commande (Cfg_LS), le signal de commande (Cfg_LS) étant HAUT lorsque le signal de commande (Cfg_LS) indique que le pré-excitateur est utilisé comme excitateur côté bas, et le signal de commande (Cfg_LS) étant BAS lorsque le signal de commande (Cfg_LS) indique que le pré-excitateur est utilisé comme excitateur côté haut ; et une deuxième résistance (R1), branchée entre la grille et la source du sixième transistor à effet de champ (Mreverse).

7. Pré-excitateur selon la revendication 1, **caractérisé en ce que** le deuxième transistor à effet de champ (Mpd) est un transistor à effet de champ doté d'un anneau isolé de type N.
